# EUROPÄISCHE PATENTSCHRIFT

(11) **EP 3 376 901 B1**
(45) Veröffentlichungstag und Bekanntmachung des Hinweises auf die Patenterteilung: **24.06.2020**
(21) Anmeldenummer: 16800888.6
(22) Anmeldetag: 03.11.2016
(51) Int. Cl.: A47B 96/20, B32B 17/00, E04F 15/00, E04B 2/72, E04C 2/00, H02G 3/38, H05K 3/00

(54) **PLATTENKÖRPER**
PANEL ELEMENT
CORPS EN FORME DE PLAQUE

(30) Priorität: 17.11.2015 DE 202015007865 U; 20.11.2015 DE 202015007999 U
(43) Veröffentlichungstag der Anmeldung: 26.09.2018
(73) Patentinhaber: Parador GmbH, 48653 Coesfeld (DE)
(72) Erfinder: PETERSEN, Frank, 48653 Coesfeld (DE); VERSTEGGE, Christian, 48599 Gronau-Epe (DE); DAMIECKI, David, 48653 Coesfeld (DE); WOLF, Matthias, 48653 Coesfeld-Lette (DE)
(74) Vertreter: Von Rohr Patentanwälte Partnerschaft mbB
(86) Internationale Anmeldenummer: PCT/EP2016/025134
(87) Internationale Veröffentlichungsnummer: WO 2017/084759

(56) Entgegenhaltungen:
- WO-A2-2010/129281
- DE-A1- 10 239 579
- DE-A1-102008 062 809
- DE-A1-102009 020 627
- DE-U1-202014 003 058
- US-A1- 2008 037 284

## Beschreibung

Die Erfindung betrifft einen Plattenkörper für einen Boden-, Wand- oder Deckenbelag, für ein Möbel oder eine Fassade, mit einer Trägerplatte und einer oberseitigen Deckschicht oberhalb der Trägerplatte.

Bei bekannten Plattenkörpern, beispielsweise zur Boden- oder Wandverkleidung, sind die Ausgestaltungsmöglichkeiten in der Regel auf die Erzielung eines bestimmten optischen Eindrucks und auf die Gebrauchstauglichkeit im Alltag beschränkt. Funktionale Elemente jeglicher Art müssen jeweils in situationsangepasster Weise installiert werden. Dies erfordert neben einer sorgfältigen Planung in der Regel auch eine Festlegung auf gewünschte Funktionen im Vorfeld des Verbaus von Plattenkörpern der vorgenannten Art.

Bei einem Bauprozess für ein Gebäude sind in der Regel mehrere Gewerke notwendig, um eine Wand oder einen Boden des Baukörpers vollständig auszurüsten. Funktionale Elemente wie Leuchten, Anschlüsse und die entsprechenden Zuleitungen müssen installiert werden. Die Oberfläche wird daraufhin in der gewünschten Weise insbesondere mit Plattenkörpern wie Paneelelementen verkleidet. Eine solch aufwendige Installation ist häufig nur beim Neubau wirtschaftlich sinnvoll, während eine nachträgliche Installation mit hohen Kosten verbunden ist, sofern sie überhaupt möglich ist.

Aus der DE 10 2012 214 379 A1 ist ein Untergrundbelag bekannt, bei dem mittels einer Sensorschicht Sensoren zur Messung einer physikalischen Größe bzw. eines Umgebungsparameters in den Bodenbelag integriert werden. Dadurch lässt sich ein Raum in unauffälliger Weise mit derartigen Sensoren ausstatten. Dieses Prinzip besitzt jedoch ebenso wie die Verwendung separater, externer Sensoren den Nachteil, dass zur Nutzung bzw. Auswertung der Sensorsignale, um beispielsweise gebäudetechnische Anlagen automatisiert zu steuern, ein großer Aufwand im Zusammenhang mit der Kontaktierung der integrierten Sensoren betrieben werden muss. Dies gilt insbesondere für die Einbindung der Sensoren der Sensorschicht in ein Smart-Home-System.

Smart-Home-Anwendungen finden zunehmend Verbreitung. Hierzu zählen beispielsweise die Automatisierung von Gebäudefunktionen und die Verflechtung elektronischer Komponenten mit dem Wohnraum, insbesondere unter Verwendung eines Bussystems. Es besteht jedoch in diesem Zusammenhang die Problematik, dass Systeme für Smart-Home-Anwendungen auf unterschiedlichen Standards basieren. Zusätzlich zur Festlegung der räumlichen Anordnung funktionaler Elemente ist bei einem Bauprozess auch die Entscheidung für einen solchen Standard in der Regel bereits im Vorfeld notwendig.

Aus der DE 10 2008 062 809 A1 ist ein Einrichtungsgegenstand mit einem Mehrschichtsystem zur Bereitstellung einer elektrischen Funktionalität bekannt, der ein Verbundelement und eine Trägerschicht aufweist. Das Verbundelement umfasst in dieser Schrift ein Dekoroberflächenlaminat und eine funktionale Schicht. Die funktionale Schicht weist ein elektrisches Element mit der elektrischen Funktionalität auf.

Aus der DE 10 239 579 A1 ist ein Dekorationselement bekannt, welches einen Grundkörper mit einer dekorierten Oberfläche aufweist, die eine Aussparung aufweist. Eine innen oder unter der Aussparung vorgesehene Beleuchtungseinheit weist eine transparente Deckschicht, eine einfallendes Licht reflektierende Funktionsschicht und eine Lichtquelle auf. Durch die Funktionsschicht und die Deckschicht kann Licht eingestrahlt werden.

Aus der DE 10 2009 020 627 A1 ist ein Möbel bekannt, das so gestaltet werden soll, dass die Elemente zum Steuern der elektromotorischen Antriebe, der Lichtquellen und auch die Informationen enthaltenden Elemente nicht als störend empfunden werden. So werden daher Flächen des Möbels mit mindestens einer Funktionsbeschichtung versehen.

Die DE 20 2014 003 058 U1 thematisiert ein Verbundkörper, umfassend einen Träger, ein erstes Dekorpapier und eine zwischen Träger und erstem Dekorpapier angeordnete elektrische leitfähige Struktur, der dadurch gekennzeichnet ist, dass mindestens ein elektrischer Leiter die elektrisch leitfähige Struktur mit einer elektronischen Schaltung verbindet und das erste Dekorpapier oberhalb der elektrisch leitfähigen Struktur zu deren Abdeckung angeordnet ist.

Vor diesem Hintergrund ist es Aufgabe der vorliegenden Erfindung, die Flexibilität beim Einsatz funktionaler Elemente im Zusammenhang mit Plattenkörpern der eingangs genannten Art zu erhöhen und den Anwendungsbereich von Plattenkörpern entsprechend zu vergrößern. Des Weiteren zeigt die US 2008/0037284 A1 einen gattungsgemäßen Plattenkörper.

Die vorgenannte Aufgabe wird erfindungsgemäß bei dem Plattenkörper der vorgenannten Art mit den Merkmalen des Anspruchs 1 gelöst.
Erfindungsgemäß ist vorgesehen, dass zwischen der Trägerplatte und der Deckschicht wenigstens eine eine gedruckte Schaltung aufweisende Funktionsschicht mit wenigstens einem Aktor in Form einer Leuchtschicht und/oder mit wenigstens einem mechanischen Aktor und/oder mit wenigstens einer Leiterbahn zur Energieübertragung von elektrischem Strom an einen externen Verbraucher vorgesehen ist.

Im Hinblick auf eine Verwendung des Plattenkörpers als Boden-, Wand- oder Deckenbelag wird das Verlegen bzw. allgemein die Montage der erfindungsgemäßen Plattenkörper durch korrespondierende Nut-Feder-Verbindungsgeometrien an gegenüberliegenden Randseiten des Plattenkörpers vereinfacht. In diesem Zusammenhang hat das Prinzip einer sogenannten Klickverbindung weite Verbreitung gefunden. Durch eine solche Klickverbindungsgeometrie lassen sich die erfindungsgemäßen Plattenkörper mit geringem personellen und technischen Aufwand verlegen.

Die Ausgestaltung der erfindungsgemäßen Plattenkörper bzw. der korrespondierenden Verbindungsgeometrien an den gegenüberliegenden Randseiten zielt auf eine verbesserte Kontaktierung der Funktionsschicht benachbarter Plattenkörper ab. Die korrespondierenden Verbindungsgeometrien sind derart ausgebildet, dass sich beim Zusammenfügen zweier benachbarter Plattenkörper eine überlappende Kontaktierung der einander zugewandten Ränder der Funktionsschichten der benachbarten Plattenkörper im Verbindungsbereich ergibt. Hierzu wird die Funktionsschicht randseitig angefast, wobei die Fasen auf gegenüberliegenden Stirnseiten in entgegengesetzten Richtungen verlaufen. Auf diese Weise wird die Kontaktfläche gegenüber einer stirnseitig gestoßenen Berührung benachbarter Plattenkörper bzw. Funktionsschichten deutlich vergrößert, wodurch eine verlustarme Übertragung von elektrischen Strom und/oder eine störungsverminderte Datenübertragung ermöglicht wird.

Die in den Schichtaufbau eines solchen Plattenkörpers integrierte Funktionsschicht erlaubt einen flexiblen Einsatz von funktionalen Elementen im Zusammenhang mit dem Plattenkörper. Die Funktionalität hängt dabei letztlich von der Beschaffenheit bzw. Ausgestaltung der Funktionsschicht ab. Ein Aktor dient dabei zur Umsetzung eines elektrischen Signals in eine gewünschte Wirkung.

Die Integration einer Funktionalität in Form einer sogenannten Printed Intelligence in den Plattenkörper führt zu einem hohen Maß an Modularität. Dadurch ergeben sich Vorteile insbesondere gegenüber der Anordnung funktionaler Elemente hinter einer Wand- oder Bodenverkleidung. Bei der Montage der Plattenkörper, d.h. insbesondere bei der Installation eines Decken-, Wand- und/oder Bodenbelags, können Plattenkörper mit verschiedenen Funktionalitäten in gewünschter und nahezu in beliebiger Weise miteinander kombiniert werden. Bei einer Veränderung der Anwendungssituation lassen sich funktionale Elemente, die durch in den Plattenkörper integrierte Aktoren gebildet werden, leicht anpassen. Dies kann im einfachsten Fall durch einen simplen Austausch des Plattenkörpers gegen einen neuen Plattenkörper mit einer entsprechend anders gestalteten Funktionsschicht erfolgen. Im Falle einer Boden-,Wand- und/oder Deckenverkleidung wird eine Anpassung der funktionalen Elemente dementsprechend erleichtert, da die funktionalen Elemente als Aktoren in der Funktionsschicht des von außen zugänglichen Boden-, Wand- bzw. Deckenbelags vorgesehen sind. Ein Austausch dieser Elemente ist demnach mit deutlich geringerem Aufwand verbunden, als ein Austausch von Elementen hinter einer solchen Verkleidung.

Durch die Integration funktioneller Einheiten in den Plattenkörper wird die gewünschte Funktionalität bereitgestellt und gleichzeitig ein dezentes und ansprechendes optisches Erscheinungsbild einer mit den erfindungsgemäßen Plattenkörpern verkleideten Oberfläche erreicht. Dies gilt insbesondere für den inaktiven Zustand der funktionalen Einheiten. Es ist beispielsweise möglich, dass eine Leuchtschicht im Plattenkörper zu Beleuchtungszwecken eingesetzt wird, jedoch kein Leuchtmittel sichtbar ist, wenn auf eine künstliche Beleuchtung verzichtet werden kann oder soll.

Weist die Funktionsschicht wenigstens eine Leiterbahn auf, so kann elektrischer Strom in unauffälliger Weise, das heißt ohne sichtbare Leitungen, zu einer Nutzungsstelle, beispielsweise einem weiteren Plattenkörper mit einem funktionalem Element, übertragen werden. Die Leiterbahn dient hierbei zur Energieübertragung zu einem externen elektrischen Verbraucher. Extern bedeutet in diesem Zusammenhang, dass der Verbraucher nicht Teil des betreffenden Plattenkörpers ist, also mit diesem nur elektrisch koppelbar ist. Zur Energieübertragung weist die Leiterbahn daher einen größeren Leitungsquerschnitt auf als die leitenden Verbindungen einer beispielsweise als integrierter Schaltkreis ausgebildeten gedruckten Schaltung.

Der Leitungsquerschnitt der Leiterbahn zur Energieübertragung beträgt vorzugsweise wenigstens 0,005 mm², bevorzugt wenigstens 0,01 mm², weiter bevorzugt wenigstens 0,05 mm² und besonders bevorzugt wenigstens 0,1 mm². Dadurch wird die Erwärmung der Leiterbahn bei der Stromleitung auf ein vertretbares Maß beschränkt, selbst wenn höhere Stromstärken zur Energieversorgung eines leistungsstärkeren Verbrauchers oder einer Mehrzahl von Verbrauchern übertragen werden.

Im Gegensatz zu Stromleitungen, die hinter einem Plattenkörper vorgesehen sind, ist es bei der erfindungsgemäßen Lösung in einfacher Weise möglich, die über die Leiterbahn in Inneren des Plattenkörpers bereitgestellte elektrische Energie zu nutzen. Dazu kann wenigstens ein vorderseitig und/oder rückseitig und/oder stirnseitig des Plattenkörpers angeordnetes Anschlusselement zur Kontaktierung der Leiterbahn dienen.

Der erfindungsgemäße Plattenkörper zeichnet sich durch ein besonders einfachen und damit kostengünstig herzustellenden Aufbau aus, wenn die Funktionsschicht unmittelbar auf die Trägerplatte aufgedruckt ist. Alternativ oder zusätzlich kann die gedruckte Schaltung auch auf einen Schichtträger aufgebracht und als separate Schicht zur Verbindung mit der Trägerplatte ausgebildet sein. Dadurch wird ein hoher Integrationsgrad erreicht. Die Bauhöhe eines mit einer Funktionsschicht ausgerüsteten Plattenkörpers wird durch den Direktdruck der Schaltung auf die Trägerplatte nur in geringem Maß vergrößert. Der direkte Druck einer Schaltung auf die Trägerplatte hat den Vorteil, dass keine weiteren Schichten als Träger der gedruckten Schaltung in den Schichtenverbund des Plattenkörpers integriert werden müssen.

Wird die gedruckte Schaltung alternativ oder zusätzlich als separate Schicht ausgebildet, insbesondere durch Aufbringung der Schaltung auf einen Schichtträger, ist es dagegen möglich, mit geringem Aufwand aus einer Vielzahl von vorbereiteten Funktionsschichten bedarfsweise eine geeignete auszuwählen und in den Schichtenverbund des Plattenkörpers vor dessen letztlicher Herstellung einzubringen.

Die Ausbildung der Deckschicht hinsichtlich ihrer Lichtdurchlässigkeit ist an die Funktionsschicht angepasst. Ist die Funktionsschicht in Form einer Leuchtschicht ausgebildet, ist die Deckschicht zumindest bereichsweise transparent oder transluzent bzw. semi-transparent. Eine derartige Ausbildung kann, muss aber dann nicht vorgesehen sein, wenn die Funktionsschicht mit wenigstens einem mechanischen Aktor und/oder nur zur Energieübertragung ausgebildet ist. In diesem Falle kann die Deckschicht auch lichtundurchlässig bzw. abdeckend sein.

Der Schichtaufbau wird zur Herstellung des Plattenkörpers vorzugsweise verpresst und die Schichten dadurch fest miteinander verbunden. Im Fall von Paneelen für einen Boden-, Wand- und/oder Deckenbelag ist beispielsweise das Kurztakt-Pressverfahren (KT-Verfahren) ein üblicher Herstellungsprozess. Ferner können Schicht auch aufkaschiert werden. Auch andere Fügeverfahren sind möglich, beispielsweise Laminieren, Kalandrieren, Bondieren oder Extrudieren. Zudem ist es auch möglich, nur mit einer Lackoberfläche zu arbeiten und/oder Wachs/Öl aufzutragen. Ebenso sind Pulverbeschichtungen, Folienbeschichtungen und andere Verfahren zum Oberflächenschutz möglich.

Die Herstellung des Plattenkörpers wird außerdem vereinfacht bzw. beschleunigt, wenn zur Herstellung der Funktionsschicht, das heißt zum Aufbringen der gedruckten Schaltung, ein Standarddruckverfahren eingesetzt werden kann. Dazu weist die gedruckte Schaltung zweckmäßigerweise ein mittels Digitaldruck und/oder Siebdruck und/oder Rollenoffsetdruck aufbringbares, leitfähiges Material auf. Hierbei lässt sich insbesondere eine Tinte gut bei einem Digitaldruckverfahren verarbeiten, während bei anderen Druckverfahren eine entsprechende Druckfarbe eingesetzt wird. Die Tinte bzw. Druckfarbe erhält ihre für die Schaltung erforderliche Leitfähigkeit vorzugsweise durch enthaltene leitfähige Partikel, insbesondere Silberpigmente.

Ist die Funktionsschicht als Leuchtschicht ausgebildet oder ist eine Leuchtschicht in der Funktionsschicht vorgesehen, so ist die Leuchtschicht bei einer bevorzugten Ausführungsform als Elektrolumineszenzschicht, insbesondere in Form einer Folie, ausgebildet. Eine Elektrolumineszenzfolie zeichnet sich durch eine weitgehend homogene Lichtabgabe über ihre gesamte Fläche aus. Sie kann zudem in einfacher Weise, beispielsweise durch Beschnitt, in eine nahezu beliebige Form gebracht werden. Durch ihre hohe mechanische Flexibilität wird zudem das Risiko einer Beschädigung der Leuchtschicht durch äußere Einwirkungen, etwa beim Betreten eines Plattenkörpers eines Bodenbelags, erheblich verringert.

Eine Abstrahlschicht im Schichtaufbau des Plattenkörpers kann dazu dienen, von der Funktionsschicht abgegebene Licht- und/oder Wärmestrahlung zu reflektieren. Durch die Anordnung einer solchen Abstrahlschicht unterhalb der Funktionsschicht werden somit Strahlungsverluste verringert und eine zur Oberfläche des Plattenkörpers gerichtete Abstrahlung gewährleistet.

Eine Abstrahlschicht kann alternativ oder zusätzlich auch oberhalb der Funktionsschicht angeordnet sein. Auf diese Weise lässt sich eine ungewünschte elektromagnetische Emission ("Elektrosmog") vermeiden oder zumindest verringern. Die Abstrahlschicht kann zu diesem Zweck vollflächig ausgebildet sein oder auch eine Gitterstruktur aufweisen.

Durch eine Kühlschicht lässt sich beispielsweise Abwärme von elektronischen bzw. stromführenden Komponenten abführen. Eine solche Kühlschicht kann darüber hinaus auch zur Temperierung des Plattenkörpers dienen, beispielsweise um ein bestimmtes Temperaturempfinden bei der Berührung des Plattenkörpers zu erzielen. Durch die Kühlschicht kann zudem die Temperatur in einem Raum mit erfindungsgemäßen Plattenkörpern beeinflusst werden. Als besonders vorteilhaftes Material für eine derartige Kühlschicht haben sich sogenannte Phasenwechselmaterialien herausgestellt, die auch bei Latentwärmespeichern eingesetzt werden. Diese können eine große Wärmemenge aufnehmen, ohne dass sich ihre Temperatur nennenswert erhöht, da ihre latente Schmelzwärme, Lösungswärme und/oder Absorptionswärme deutlich größer ist als die Wärme, die sie aufgrund ihrer spezifischen Wärmekapazität aufnehmen können.

Erfindungsgemäß ist der Funktionsschicht wenigstens ein Sensor zugeordnet, mit dem eine physikalische Größe erfasst werden kann. Der Sensor dient erfindungsgemäß zur Ermittlung der Temperatur, der Beleuchtungsstärke, von auf den Plattenkörper wirkender Feuchtigkeit und/oder eines auf den Plattenkörper wirkenden Drucks. Das Signal des Sensors kann dazu genutzt werden, Stellglieder eines Regelkreises derart zu steuern, dass ein Sollwert für die gemessene physikalische Größe erreicht wird. Dies betrifft beispielsweise die Temperatur oder die Beleuchtungsstärke. Die Stellglieder eines Regelkreises, die aufgrund eines Sensorsignals aktiviert bzw. angesteuert werden, können sowohl außerhalb des Plattenkörpers vorgesehen sein als auch in Form von Aktoren der Funktionsschicht des Plattenkörpers vorliegen.

Mit einem Drucksensor kann die Berührung des Plattenkörpers detektiert werden. Auf diese Weise lässt sich z. B. zu Überwachungszwecken feststellen, ob ein Raum betreten wird, wenn sein Bodenbelag einen erfindungsgemäßen Plattenkörper aufweist. Ferner kann durch einen Bodenbelag mit jeweils Drucksensoren aufweisenden Plattenkörpern beispielsweise registriert werden, wenn eine hilfsbedürftige Person fällt, so dass entsprechende Hilfsmaßnahmen eingeleitet werden können.

Der Sensor kann dabei in der Funktionsschicht und/oder einer separaten zusätzlichen Sensorschicht vorgesehen sein. Hierbei ergeben sich unterschiedliche Vorteile in Abhängigkeit von der Beschaffenheit des Sensors. Durch die Anordnung des Sensors in der Funktionsschicht erhöht sich der Integrationsgrad, so dass eine insgesamt platzsparende Konstruktion der Funktionsschicht bzw. des Plattenkörpers als solchen möglich ist. In anderen Fällen kann es erforderlich sein, den Sensor von der Funktionsschicht zu entkoppeln, beispielsweise um ihn im Schichtaufbau näher zur Oberfläche des Plattenkörpers anzuordnen.

Durch wenigstens eine Bedienungseinrichtung zur Steuerung der Funktionsschicht lässt sich durch einen Benutzer Einfluss auf das Verhalten eines Aktors in der Funktionsschicht nehmen. Die Bedienungseinrichtung kann darüber hinaus auch genutzt werden, um Steuersignale an ein funktionales Element zu leiten, das außerhalb des Schichtaufbaus des Plattenkörpers angeordnet ist. Die Bedienungseinrichtung ist vorzugsweise in der Funktionsschicht vorgesehen.

Die Funktionsschicht, der Sensor und/oder die Bedienungseinrichtung sind vorzugsweise mit einer Steuereinrichtung gekoppelt. Mittels der Steuereinrichtung lässt sich die Funktionsschicht bzw. funktionale Elemente, wie Aktoren der Funktionsschicht, steuern und/oder regeln, wobei die Steuerung bzw. Regelung auch lediglich bereichsweise erfolgen kann. Durch eine solche Steuereinrichtung ist es möglich, über simple Schaltvorgänge hinausgehend auch komplexere Möglichkeiten der Ansteuerung von Aktoren, insbesondere von Aktoren der Funktionsschicht, zu realisieren. Dazu können über die Bedienungseinrichtung beispielsweise Steuerprogramme der Steuereinrichtung aufgerufen und aktiviert werden.

Programmierte Steuerabläufe können darüber hinaus auch initiiert werden, wenn die Steuereinrichtung ein bestimmtes Sensorsignal registriert. Dies kann insbesondere mit dem Über- oder Unterschreiten eines vorgegebenen Sollwertes für eine physikalische Größe in Zusammenhang stehen. Im Hinblick auf eine kompakte Baugröße und einen hohen Integrationsgrad ist die Steuereinrichtung vorzugsweise in der Funktionsschicht vorgesehen.

Die Steuereinrichtung und/oder die Bedienungseinrichtung kann zudem auch fernsteuerbar ausgebildet sein. Hierbei ist sowohl eine Fernsteuerung durch vergleichsweise einfache Funk- und/oder Infrarotsignale als auch mittels komplexerer Methoden, wie beispielsweise mittels Bluetooth-Technologie, möglich. Die Steuereinrichtung und/oder die Bedienungseinrichtung kann dementsprechend auch zum Datenaustausch ausgebildet sein. Eine Bluetooth-Schnittstelle erlaubt in diesem Zusammenhang sowohl die Übertragung digitaler Steuerdaten zur Steuerung funktionaler Elemente als auch eine Übermittlung beliebiger anderer Nutzdaten.

Ein der Steuereinrichtung zugeordneter Datenspeicher erlaubt die Speicherung von übertragenen Daten zum Zweck eines zeitversetzten und/oder wiederholten Abrufs der Daten. Der Datenspeicher ist dabei vorzugsweise in der Funktionsschicht vorgesehen. Es versteht sich, dass auch eine Mehrzahl von Datenspeichern vorgesehen sein kann.

Bei einer bevorzugten Ausgestaltung weist die Bedienungseinrichtung wenigstens ein Bedienelement zur Eingabe und/oder Ausgabe von Daten auf. Das Bedienelement erfüllt also die Funktion einer Benutzerschnittstelle. Über das Bedienelement kann beispielsweise eine neue Programmierung der Steuereinrichtung vorgenommen werden, indem Steuerdaten und/oder Sollwertvorgaben eingegeben werden. Durch eine Datenausgabe kann eine Rückmeldung an einen Benutzer erfolgen, etwa zur Bestätigung eingegebener Daten oder wenn eine Datenübertragung erfolgreich abgeschlossen wurde.

Darüber hinaus ist eine Signalisierung für den Benutzer möglich, wenn ein mittels eines Sensors gemessener Wert außerhalb eines vorgegebenen Bereichs liegt. Die Ausgabe von Daten durch das Bedienelement der Bedienungseinrichtung ist nicht auf eine optische Ausgabe beschränkt, sondern kann alternativ oder zusätzlich auch eine mechanische und/oder akustische Signalisierung umfassen, beispielsweise in Form einer Vibration mit einer fühlbaren und/oder hörbaren Frequenz.

Vorzugsweise weist die Bedienungseinrichtung wenigstens einen Druckschalter und/oder ein kapazitives Element auf. Ein Druckschalter kann dabei einfache Schaltaufgaben übernehmen und insbesondere als Taster dienen. Durch ein kapazitives Element ergeben sich darüber hinaus weitere Möglichkeiten. Bei einem solchen Element lassen sich verschiedene Bereiche einer Eingabefläche zur Ausführung verschiedener Funktionen definieren. Zudem unterstützt ein kapazitives Element auch Bedienungsformen, die über die Funktion eines reinen Drucktasters hinausgehen. So erlauben beispielsweise Wischgesten die Einstellung von Werten in Anlehnung an die Funktionsweise eines Schiebereglers anstelle der Eingabe eines konkreten Wertes. Dadurch kann etwa eine Dimmersteuerung für eine Beleuchtungseinrichtung oder ähnliches realisiert werden.

Durch eine wenigstens ein piezoelektrisches Element aufweisende Schaltung, die der Funktionsschicht zugeordnet ist, lässt sich ein Drucksensor und/oder ein Druckschalter, insbesondere unabhängig von einer Energieversorgung, realisieren. Die Schaltung kann darüber hinaus derart ausgebildet sein, dass von dem piezoelektrischen Element infolge einer Druckausübung getrennte Ladungen gespeichert werden und als Quelle zur Bereitstellung von elektrischer Energie zur Verfügung stehen.

Alternativ oder zusätzlich kann das piezoelektrische Element auch als Aktor betrieben werden. Hierbei bewirkt ein elektrisches Signal eine mechanische Deformation des Piezokristalls. Die Frequenz einer angelegten, sich im zeitlichen Verlauf periodisch ändernden Spannung kann auf diese Weise fühlbar und/oder hörbar gemacht werden.

Ein schallemittierendes Element stellt eine Sonderform eines mechanischen Aktors dar, bei der eine mechanische Schwingung mit entsprechender Frequenz und ausreichender Amplitude akustisch wahrnehmbar ist. Durch wenigstens ein der Funktionsschicht zugeordnetes schallemittierendes Element zur aktiven Lärmkompensation ist es möglich, Trittschall oder allgemein Raumschall zu reduzieren. Dabei wird von einem akustischen Sensor erfasster Schall über das schallemittierende Element mit gleicher Frequenz, jedoch mit einem Phasenschub von einer Halbwelle wiedergegeben, so dass sich die empfangene und die abgegebene Schallwelle nach dem Prinzip der destruktiven Interferenz gegenseitig auslöschen. Dadurch kann eine akustisch ruhige Umgebung erzeugt werden, wie sie in Wohnbereichen oftmals gewünscht ist oder in bestimmten Bereichen, wie beispielsweise in Tonstudios oder in akustischen Messlaboren, sogar erforderlich sein kann.

Bei einer bevorzugten Ausführungsform weist die Funktionsschicht ein Mittel zur kontaktlosen Energie- und/oder Datenübertragung auf. Bei diesem handelt es sich vorzugsweise um eine Induktionsspule. Ein solches Mittel kann zur Übertragung von elektrischer Energie und/oder Daten von einem Plattenkörper zu einem anderen, insbesondere einem benachbarten Plattenkörper dienen. Dadurch erübrigt sich eine aufwendige Kontaktierung zwischen den Plattenkörpern zur Herstellung einer elektrisch leitenden Verbindung. Durch das Mittel zur kontaktlosen Energie- und/oder Datenübertragung kann zudem auch ein Zugang zur Funktionsschicht bzw. zu funktionalen Elementen, d.h. beispielsweise zu Aktoren, Sensoren und/oder einer Steuereinrichtung, von außen ermöglicht werden. Dadurch lassen sich insbesondere Daten kontaktlos zur Steuereinrichtung übertragen.

Darüber hinaus können elektronische Geräte, wie Smartphones, Tablet-Computer oder dergleichen, kontaktlos durch Induktion geladen werden. Hierzu weist ein erfindungsgemäßer Plattenkörper, beispielsweise bei einem Möbelstück, vorzugsweise eine entsprechende Induktionsfläche oder einen Induktionsbereich auf. Zu ladende Geräte werden für den Ladevorgang lediglich auf der Induktionsfläche abgelegt. Der kontaktlose Ladevorgang kann dabei insbesondere nach dem Qi- oder dem Powermat-Standard erfolgen.

Die Funktionsschicht kann darüber hinaus wenigstens einen Beschleunigungssensor zur Messung von insbesondere seismischen Erschütterungen aufweisen. Mittels des Beschleunigungssensors lassen sich, ähnlich wie mit einem Drucksensor, Berührungen und/oder Bewegungen des Plattenkörpers detektieren. Dies ermöglicht unter anderem die Überwachung eines Raumes auf das Betreten durch eine Person hin. Ferner erlaubt ein solcher Beschleunigungssensor in Bereichen, in denen die Dokumentation von seismischen Aktivitäten erforderlich ist, beispielsweise in Museen, die Messung unauffällig in Elemente des Raumes zu integrieren. Auf sichtbare und einer möglichen Manipulation ausgesetzte Messinstrumente kann in diesem Fall verzichtet werden.

Mittels einer entsprechenden Ausbildung der gedruckten Schaltung lässt sich ein Magnetfeld erzeugen. Dieses ist insbesondere stationär, das heißt es ändert sich im zeitlichen Verlauf nicht oder nicht wesentlich. Die Magnetfeldlinien eines solchen Magnetfeldes verlaufen bevorzugt zumindest teilweise außerhalb des Plattenkörpers. Objekte bzw. Geräte können in diesem Fall mit dem Magnetfeld interagieren. Beispielsweise lassen sich auf diese Weise Fahrwege für selbstfahrende Objekte wie Spielzeuge, Staubsaugerroboter oder ähnliche festlegen.

Alternativ oder zusätzlich kann auch im Inneren des Plattenkörpers, insbesondere in der Funktionsschicht und/oder in der Deckschicht, ein mit dem Magnetfeld wechselwirkendes Material vorgesehen sein. Ein ferromagnetisches Granulat oder ein Ferrofluid ist durch das Magnetfeld beeinflussbar. Bei Anwesenheit eines Magnetfeldes ordnet sich ein solches Material entsprechend den magnetischen Feldlinien an, wodurch auf die räumliche Struktur des Materials Einfluss genommen werden kann.

Ein Ferrofluid unter einer transparenten Deckschicht kann so beispielsweise zur Ausbildung bestimmter dekorativer Muster angeregt werden. Ein Granulat aus einem ferromagnetischen Material kann unterhalb oder innerhalb einer elastischen Deckschicht durch ein Magnetfeld derart angeordnet werden, dass sich an der Oberseite des Plattenkörpers ein fühlbares Relief bildet. Ein solches Relief kann beispielsweise zur Rutschhemmung auf der Oberfläche oder zur Nachahmung einer natürlichen Oberflächenstruktur dienen.

Beim Abschalten des Magnetfeldes verlässt ein magnetempfindliches Material die durch das Magnetfeld erzwungene Form wieder. Ein Muster bzw. eine Grafik, die durch ein Ferrofluid gebildet wurde, verschwindet in diesem Fall. Ein durch eine entsprechende Anordnung eines magnetempfindlichen Granulats ausgebildete Reliefstruktur an der Oberfläche des Plattenkörpers flacht ab, so dass beispielsweise eine Reinigung des Plattenkörpers erleichtert wird.

Durch wenigstens ein photovoltaisches Element, das heißt insbesondere eine Photovoltaikzelle, lässt sich die Funktionsschicht energieautark betreiben. Die Notwendigkeit einer äußeren Energieversorgung über Zuleitungen für den Betrieb funktionaler Elemente entfällt dadurch. Insbesondere bei einer Nutzung des erfindungsgemäßen Plattenkörpers als Fassadenelement, das dem Tageslicht ausgesetzt ist, ist auch eine Funktion als Energiequelle für weitere Verbraucher außerhalb des Plattenkörpers möglich.

Um Veränderungen bei der Bereitstellung von insbesondere elektrischer Energie zu kompensieren, ist es zweckmäßig, wenn die Funktionsschicht wenigstens einen Energiespeicher aufweist. Bei dem Energiespeicher kann es sich insbesondere um eine Dünnschichtbatterie oder eine sogenannte Micro Energy Cell (MEC) handeln. Eine solche Mikrobatterie kann insbesondere in gedruckter Form vorgesehen sein.

Die Ladung des Energiespeichers kann außer über elektrische Zuleitungen von außen auch durch ein piezoelektrisches und/oder ein photovoltaisches Element geladen werden. Dadurch wird benötigte elektrische Energie von dem Plattenkörper bzw. von der Funktionsschicht selbst bereitgestellt und steht aufgrund der Speicherung im Energiespeicher kontinuierlich und insbesondere unabhängig von ihrer Generation zur Verfügung.

Zum Betrieb insbesondere externer elektrischer Verbraucher benötigte Energie kann durch die Funktionsschicht eines erfindungsgemäßen Plattenkörpers bereitgestellt werden. Dazu weist die Funktionsschicht vorzugsweise wenigstens ein Anschlussmittel zur elektrischen Kontaktierung eines elektrischen Verbrauchers auf. Das Anschlussmittel kann als Steckkontakt in Form einer Buchse oder als Kontaktfläche ausgebildet sein. Erfindungsgemäß möglich ist darüber hinaus auch, dass die Funktionsschicht zwei spannungsführende Schichten unterschiedlicher Polarität übereinander aufweist. Diese Schichten können bei einem entsprechenden System aus dem Plattenkörper und dem Verbraucher von einem elektrischen Verbraucher kontaktiert werden, indem mit unterschiedlich langen Elektroden des Verbrauchers die Deckschicht bzw. die Funktionsschicht durchstoßen werden, so dass die Elektrodenspitzen mit der spannungsführenden Schicht entsprechender Polarität in Kontakt geraten.

Die Funktionsschicht kann je nach Einsatz- bzw. Anwendungszweck sowohl vollflächig als auch teilflächig auf dem Plattenkörper vorgesehen sein. Die Ausbildung der Funktionsschicht kann also auf diejenigen Bereiche des Plattenkörpers beschränkt sein, in denen funktionale Elemente vorgesehen sein sollen.

Im Zusammenhang mit der Erfindung ist festgestellt worden, dass beim Druck der Elektronik auf den Plattenkörper oder ein Substrat ein minimaler Höhenaufbau dort entsteht, wo die Elektronik beispielsweise in Form des Sensors, Aktors oder der Leiterbahn gedruckt wird. Es ist weiter festgestellt worden, dass diese Kontur auch nach Abdeckung mit einem Dekorpapier oder einer anderen Nutzschicht im fertigen Produkt noch sichtbar ist. Dies ist jedoch unerwünscht. Damit derartige Konturen der Funktionsschicht nicht sichtbar sind, ist bei der Erfindung eine Negativmaskenschicht zum Ausgleich von überstehenden Konturen der Funktionsschicht vorgesehen. Bevorzugt ist die Negativmaskenschicht unmittelbar oberhalb und/oder unterhalb der Funktionsschicht angeordnet.

Grundsätzlich ist es möglich, dass sich die Negativmaskenschicht über die gesamte Ober- und/oder Unterseite des Plattenkörpers erstreckt. Wird die Negativmaskenschicht vollflächig aufgebracht, ist es so, dass sie im Bereich der Funktionsschicht eine geringere Schichtdicke hat als in Bereichen, wo keine Funktionsschicht vorgesehen ist. Von besonderer Bedeutung ist in diesem Zusammenhang insbesondere, dass die Oberseite der Negativmaskenschicht über ihre gesamte Fläche eben ist, es sich also eine absolut ebene Fläche ergibt, auf die dann weitere Schichten, insbesondere die Deckschicht aufgebracht werden kann.

Bei einer besonderen Ausgestaltung der Erfindung ist die Negativmaskenschicht als Lackschicht ausgebildet, wobei der Lack der Lackschicht zumindest alle Bereiche ausfüllt, die nicht schon vorher bedruckt waren. Die Lackschicht kann sich auch über die Funktionsschicht erstrecken. Im Falle einer Leuchtschicht als Funktionsschicht sollte die Lackschicht in diesem Falle durchsichtig oder transluzent sein. Ansonsten spielt die Lichtdurchlässigkeit der Lackschicht keine Rolle.

Alternativ ist es möglich, dass die Negativmaskenschicht wenigstens einen Ausschnitt aufweist, in dem die überstehenden Konturen der Funktionsschicht angeordnet sind. Die Dicke der Negativmaskenschicht ist in diesem Falle so ausgebildete, dass die Oberseite der Negativmaskenschicht und die Oberseite der Funktionsschicht miteinander ausgefluchtet sind.

Die Funktionsschicht ist zudem nicht auf ein einziges funktionales Element beschränkt. Das heißt die Funktionsschicht kann auch eine Mehrzahl von funktionalen Elementen oder allgemein Funktionsgruppen enthalten, die ihrerseits jeweils ein oder mehrere funktionale Elemente, vorzugsweise in Form von gedruckten Schaltungen, aufweisen können. Bevorzugt sind innerhalb einer gemeinsamen Funktionsschicht wenigstens zwei insbesondere unterschiedliche Funktionsgruppen, vorzugsweise gedruckte Schaltungen, vorgesehen.

Im Fall einer Mehrzahl von Funktionsgruppen können diese innerhalb der Funktionsschicht in einer gemeinsamen Ebene benachbart angeordnet sein. Die Funktionsgruppen überlappen bzw. überlagern sich dabei vorzugsweise nicht. D.h. jeder Flächenanteil der von den Funktionsgruppen belegten Fläche ist jeweils einer Funktionsgruppe zugeordnet. Je nach Anwendungssituation kann es jedoch auch erforderlich sein, dass sich Teile der Funktionsgruppen gegenseitig überlagern bzw. überlappen. In diesem Fall kann beispielsweise die gedruckte Schaltung einer Funktionsgruppe in einem Übergangsbereich in die gedruckte Schaltung einer weiteren Funktionsgruppe übergehen. Im Übergangsbereich sind dabei vorzugsweise gemeinsame, d.h. von beiden Funktionsgruppen genutzte, elektronische Komponenten vorgesehen. Die Ebene erstreckt sich bevorzugt parallel zu wenigstens einer Flachseite des Plattenkörpers. Auf diese Weise ist es möglich, eine Vielzahl funktionaler Elemente innerhalb einer Funktionsschicht vorzusehen. Dadurch kann innerhalb eines Plattenkörpers eine entsprechende Anzahl von Funktionen realisiert werden. Ein solcher Plattenkörper bildet vorzugsweise eine funktionale Einheit, indem beispielsweise Sensoren und Aktoren zusammen mit einer Regelungselektronik im Plattenkörper integriert werden, so dass sich ein vollständiges System zur Regelung wenigstens einer physikalischen Größe ergibt.

Zum Schutz der Funktionsschicht vor mechanischer Beschädigung insbesondere durch Biegen oder eine Torsion des Plattenkörpers sowie zur weiteren Stabilisierung des Plattenkörpers als solchen kann wenigstens eine Stabilisierungsschicht insbesondere zwischen der Funktionsschicht und der Trägerplatte beitragen. Hierzu besitzt insbesondere ein Glasfasermaterial oder auch ein Polymerstoff wie Polyester geeignete mechanische Eigenschaften.

Durch eine Schutzschicht oberhalb der Funktionsschicht wird die gedruckte Schaltung vor mechanischer Beschädigung und Verschmutzung geschützt. Zusätzlich kann eine solche Schutzschicht dazu dienen, die Funktionsschicht vor eindringender Feuchtigkeit zu schützen. Hierdurch wird insbesondere das Auftreten von Unterbrechungen der Leiterbahnen und/oder Kurzschlüssen verhindert. Vorzugsweise weist die Schutzschicht einen insbesondere isolierenden Schutzlack auf.

Bei einer bevorzugten Ausführungsform des Plattenkörpers ist unterhalb der Deckschicht eine Dekorschicht vorgesehen. Dadurch lässt sich das optische Erscheinungsbild des Plattenkörpers beeinflussen. Diesem kann auf diese Weise insbesondere das Aussehen eines natürlichen Werkstoffs verliehen werden. In diesem Zusammenhang sind insbesondere eine Holz- und/oder eine Steinoptik zu nennen. Es versteht sich, dass dem Plattenkörper mittels der Dekorschicht grundsätzlich ein beliebiges Erscheinungsbild verliehen werden kann. Ebenso ist möglich, auf die Dekorschicht ganz oder teilweise zu verzichten, um bewusst Teile der Funktionsschicht nach außen hin sichtbar werden zu lassen. In diesem Falle kann die Dekorschicht auch die Funktion der Negativmaskenschicht übernehmen.

Als Träger der Dekorschicht eignet sich insbesondere ein Dekorpapier oder auch eine Folie. Die Dekorschicht und die Folie sind vorzugsweise transluzent bzw. transparent ausgebildet. Es ist dadurch möglich, die Dekorschicht mittels der Funktionsschicht zu hinterleuchten, um einen optischen Effekt, beispielsweise zur Signalisierung oder zur Raumgestaltung, zu erzielen. Der transluzente bzw. transparente Bereich des Dekorpapiers bzw. der Folie kann auch nur bereichsweise vorgesehen sein. Möglich ist darüber hinaus auch, dass ein Dekorpapier oder eine Folie sowohl transluzente als auch transparente Bereiche aufweist. Die letztliche Ausgestaltung der Dekorschicht sowie des Trägers der Dekorschicht hängt von der Anwendungssituation ab.

Die Funktionsschicht ist vorzugsweise zwischen der Trägerplatte und der Dekorschicht, d.h. ggf. auch dem Dekorpapier und/oder Folie, angeordnet. Die Funktionsschicht ist dadurch von der Unterseite her gegen mechanische Beschädigungen geschützt, während sie von der Oberseite her durch die Dekorschicht verdeckt wird, falls dies gewünscht ist. Dadurch ist die Funktionsschicht sicher und unauffällig in den Plattenkörper integriert.

Alternativ oder zusätzlich zu einem Dekorpapier und/oder einer Folie als Träger der Dekorschicht kann die Dekorschicht auch unmittelbar auf die Funktionsschicht aufgedruckt sein. Dies vereinfacht den Schichtaufbau des erfindungsgemäßen Plattenkörpers und trägt zu einer Verringerung der Bauhöhe des Plattenkörpers bei.

Wenigstens eine Gegenzugschicht unterhalb der Trägerschicht kann einer mechanischen Deformation des Plattenkörpers entgegenwirken. Durch zwei derartige Gegenzugschichten lässt sich beispielsweise bei einem Laminatboden eine Verformung aufgrund von Biegekräften infolge einer Belastung vermeiden oder zumindest verringern. Bei zwei Gegenzugschichten müssen diese dabei nicht gleichartig ausgebildet sein, sondern können insbesondere unterschiedliche Schichtdicken und/oder unterschiedliche Materialien aufweisen.

Ein System mit einer Mehrzahl von Plattenkörpern, beispielsweise ein Boden-, Wand- oder Deckenbelag, jedoch auch eine Fassadenverkleidung oder ein aus Plattenkörpern zusammengesetztes Möbelstück, wird durch wenigstens einen erfindungsgemäßen Plattenkörper mit einer Funktionsschicht mit entsprechenden funktionalen Elementen ausgestattet. Hierdurch kann ein hoher Integrationsgrad bei der Verbindung von elektronischer Funktionalität mit Elementen der Raumgestaltung erreicht werden. Dies ist insbesondere im Hinblick auf zunehmend verbreitete Smart-Home-Anwendungen, beispielsweise unter Einsatz eines Bussystems, von Bedeutung.

Es versteht sich, dass ein solches System, d.h. ein Belag oder ein Möbelstück, auch eine Vielzahl erfindungsgemäßer Plattenkörper mit funktionalen Elementen aufweisen oder sogar vollständig aus solchen Plattenkörpern zusammengesetzt sein kann. Dies ist jedoch nicht zwingend erforderlich, da der erfindungsgemäße Plattenkörper derart ausgebildet werden kann, dass sein optisches und/oder haptisches Erscheinungsbild dem Erscheinungsbild gewöhnlicher Plattenkörper ohne Funktionsschicht entspricht, so dass er sich leicht in ein System aus gewöhnlichen Plattenkörpern integrieren lässt.

Aufgrund einer platzsparenden Ausgestaltung der Funktionsschicht sowie der weiteren Schichten des Schichtaufbaus ist die Bauhöhe des erfindungsgemäßen Plattenkörpers gegenüber gewöhnlichen Plattenkörpern ohne Funktionsschicht allenfalls in geringem Maße vergrößert. Insbesondere bei flächiger Anwendung einer Mehrzahl von Plattenkörpern in Form eines Systems der vorgenannten Art kann jedoch ein geringer Höhenunterschied am Übergang von einem gewöhnlichen zu einem erfindungsgemäßen Plattenkörper wahrnehmbar sein. Um dies zu vermeiden, ist es bei einem System aus einer Mehrzahl von Plattenkörpern mit wenigstens einem eine Funktionsschicht aufweisenden Plattenkörper vorzugsweise so, dass die Deckschichten benachbarter Plattenkörper unterschiedliche Schichtdicken aufweisen, so dass die Oberseiten benachbarter Plattenkörper im verlegten Zustand miteinander ausgefluchtet sind. Auf diese Weise ergibt sich eine durchgehende Oberfläche ohne wahrnehmbare Höhenstufen.

Bei einer bevorzugten Ausführungsform des erfindungsgemäßen Plattenkörpers weist die Funktionsschicht wenigstens ein Anzeigemittel bzw. einen Aktor in Form eines Anzeigemittels auf.

Das Anzeigemittel ist vorzugsweise als elektronisches Papier ausgebildet, wie es aus gängigen E-Book-Readern bekannt ist, oder weist ein solches elektronisches Papier auf. Ein elektronisches Papier, das insbesondere hintergrundbeleuchtet sein kann, hat den Vorteil, dass zur Anzeige einer gewünschten Grafik keine Erhaltungsspannung notwendig ist, wie im Fall selbstleuchtender Anzeigesysteme. Ein Spannungspuls wird lediglich zum Wechsel der Anzeige benötigt, so dass durch den Einsatz eines elektronischen Papiers eine dauerhafte und energiesparende Anzeige möglich ist.

Darüber hinaus kann ein sich über die gesamte Fläche des Plattenkörpers erstreckendes, ein elektronisches Papier aufweisendes Anzeigemittel dazu dienen, eine beliebige Grafik, insbesondere ein Muster, anzuzeigen, welche das optische Erscheinungsbild des Plattenkörpers definiert. Hierdurch lassen sich beispielsweise Maserungen von natürlichen Holz- und/oder Steinoberflächen imitieren.

Die vom Anzeigemittel in diesem Fall wiedergegebene Grafik ersetzt vorzugsweise eine separate Dekorschicht.

Elektronisches Papier ist prinzipbedingt auf die Darstellung von Grautönen zwischen schwarz und weiß beschränkt. Durch eine zusätzliche Farbfolie im Schichtaufbau des Plattenkörpers oberhalb des Anzeigemittels oder eine entsprechend getönte Deckschicht kann der Darstellung des Anzeigemittel ein zusätzlicher Farbeindruck verliehen werden, wodurch das optische Erscheinungsbild des Plattenkörpers weiter an einen natürlichen Werkstoff angenähert wird.

Weitere Merkmale, Vorteile und Anwendungsmöglichkeiten der vorliegenden Erfindung ergeben sich aus der nachfolgenden Beschreibung von Ausführungsbeispielen anhand der Zeichnung und der Zeichnung selbst. Dabei bilden alle beschriebenen und/oder bildlich dargestellten Merkmale für sich oder in beliebiger Kombination den Gegenstand der vorliegenden Erfindung, unabhängig von ihrer Zusammenfassung in den Ansprüchen oder deren Rückbeziehung.

### Es zeigt

- Fig. 1: eine schematische Schnittdarstellung einer bevorzugten Ausführungsform eines erfindungsgemäßen Plattenkörpers,
- Fig. 2: eine der Fig. 1 entsprechende Darstellung einer weiteren bevorzugten Ausführungsform des erfindungsgemäßen Plattenkörpers,
- Fig. 3: eine schematische Darstellung des Schichtaufbaus eines erfindungsgemäßen Plattenkörpers,
- Fig. 4: eine schematische Darstellung einer möglichen Anwendungssituation für eine bevorzugte Ausführungsform des erfindungsgemäßen Plattenkörpers,
- Fig. 5: eine schematische Darstellung einer möglichen Anwendungssituation für ein System mit einer Mehrzahl von Plattenkörpern in Form eines Boden- und Wandbelags,
- Fig. 6: eine schematische Darstellung eines weiteren Anwendungsfalls für ein System mit einer Mehrzahl von Plattenkörpern in Form eines Möbelstücks und
- Fig. 7: eine schematische Schnittdarstellung des Verbindungsbereichs zweier benachbarter erfindungsgemäßen Plattenkörper in einer bevorzugten Ausführungsform.

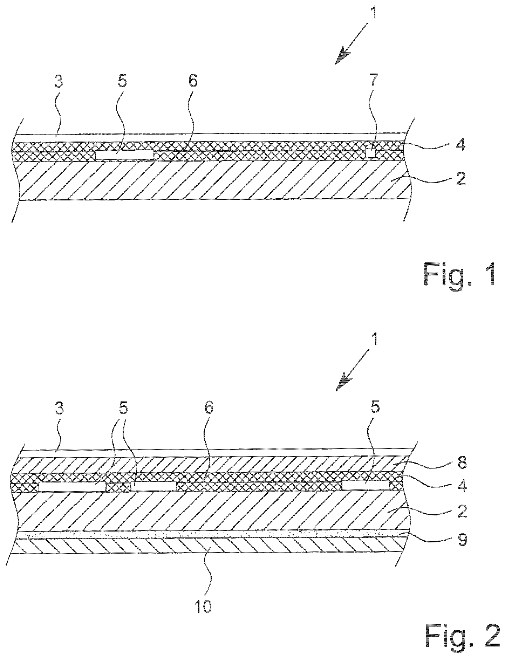

Bei dem in Fig. 1 gezeigten Plattenkörper 1 ist ein grundsätzlicher, vergleichsweise einfacher Schichtaufbau vorgesehen. Eine Trägerplatte 2 verleiht dem Plattenkörper 1 die notwendige Stabilität gegenüber mechanischer Belastung. Dadurch eignet sich der Plattenkörper 1 insbesondere als Bodenbelag, der einer Vielzahl von Belastungen ausgesetzt ist oder zur Konstruktion von Möbelstücken oder ähnlichen. Die Trägerplatte 2 ist vorzugsweise als MDF- oder HDF-Platte ausgebildet.

Oberseitig weist der Plattenkörper 1 eine transparente Deckschicht 3 auf, welche dem Plattenkörper 1 eine zusätzliche Abriebfestigkeit beim Gebrauch verleiht. Ferner kann die Deckschicht 3 auch eine nicht näher dargestellte Oberflächenstrukturierung aufweisen, wodurch ein bestimmter haptischer bzw. optischer Eindruck erzielt wird. Im Falle eines Laminats als Plattenkörper 1 handelt es sich bei der Deckschicht 3 bevorzugt um ein Melamin-Overlay, das Korundanteile aufweisen kann.

Zwischen der Trägerplatte 2 und der Deckschicht 3 ist zudem eine Funktionsschicht 4 vorgesehen. Die Funktionsschicht 4 weist im vorliegenden Beispiel einen Aktor 5 und eine Leiterbahn 6 zur Leitung von elektrischem Strom sowie einen Sensor 7 auf.

Der Aktor 5 wird über die Leitung 6 mit elektrischer Energie versorgt und kann, wie dargestellt, in einem Bereich der Funktionsschicht 4 vorgesehen sein. Alternativ kann sich der Aktor 5 auch über die gesamte Fläche des Plattenkörpers 1 bzw. durch die gesamte Funktionsschicht 4 hindurch erstrecken. Dies kann beispielsweise sinnvoll sein, wenn der Aktor 5 als Leuchtschicht, etwa als Elektrolumineszenzfolie, ausgebildet ist.

Der Aktor 5 kann auch als mechanischer Aktor ausgebildet sein. Ein piezoelektrisches Element, beispielsweise, wandelt elektrische Spannungssignale, die den Aktor 5 über die Leiterbahn 6 erreichen, in eine mechanische Deformation um. Durch eine periodische Modulation des elektrischen Signals kann somit eine Schwingung des piezoelektrischen Elements des Aktors 5 erreicht werden, die fühl- und/oder, bei entsprechender Frequenz, auch hörbar ist.

Die Funktionsschicht 4 schließt sich unmittelbar an die Trägerplatte 2 an und kann insbesondere direkt auf die Trägerplatte 2 aufgedruckt sein. Das direkte Aufbringen einer gedruckten Schaltung kann beispielsweise mittels Digitaldruck, Siebdruck und/oder Rollenoffsetdruck erfolgen. Eine silberpigmenthaltige Druckfarbe bzw. Tinte weist dabei eine ausreichende Leitfähigkeit für die Funktionsweise der Schaltung auf.

Ferner weist die Funktionsschicht 4, wie erwähnt, einen Sensor 7 auf, mittels dessen eine physikalische Größe, insbesondere die Temperatur, die Beleuchtungsstärke, auf den Plattenkörper 1 wirkende Feuchtigkeit und/oder auf den Plattenkörper 1 wirkender Druck, gemessen werden kann. Der Sensor 7 übermittelt ein vorzugsweise zum gemessenen Wert proportionales elektrisches Signal über die Leiterbahn 6 an ein weiteres funktionales Element, welches vorzugsweise ebenfalls in der Funktionsschicht 4 angeordnet ist, sich jedoch auch außerhalb des Plattenkörpers 1 befinden kann. Durch ein Zusammenspiel von Aktoren 5 und Sensoren 7 mit einer entsprechenden Steuereinrichtung lässt sich mittels der Funktionsschicht 4 des Plattenkörpers 1 ein vollständiger Regelkreis zur Regelung einer physikalischen Umgebungsvariable mit einem vorgegebenen Sollwert realisieren.

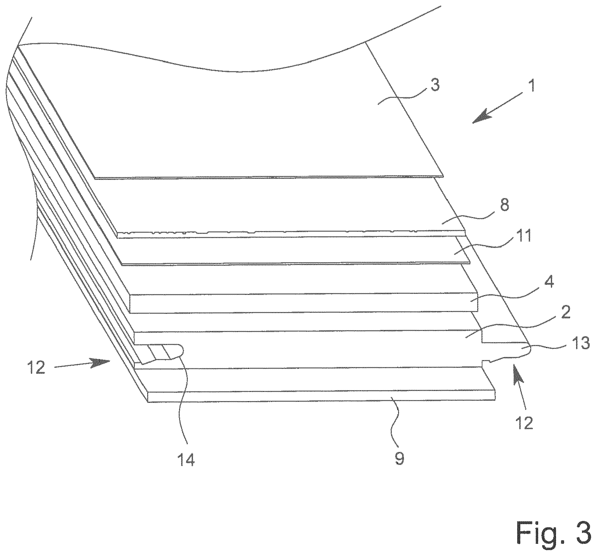

Über den in Fig. 1 gezeigten Schichtaufbau des Plattenkörpers 1 hinaus können auch, wie in den Fig. 2 und 3 gezeigt wird, weitere Schichten vorgesehen sein. Bei der in Fig. 2 gezeigten bevorzugten Ausführungsform des erfindungsgemäßen Plattenkörpers 1 ist der in Fig. 1 dargestellte Aufbau aus einer Trägerplatte 2 mit einer darüber angeordneten Funktionsschicht 4 und einer sich anschließenden Deckschicht 3 um eine Dekorschicht 8 zwischen der Deckschicht 3 und der Funktionsschicht 4 erweitert.

Die Dekorschicht 8 kann direkt auf die Funktionsschicht 4 aufgedruckt sein. Möglich ist jedoch auch das Bedrucken eines Dekorpapiers oder einer Dekorfolie. Dies erlaubt eine größere Flexibilität bei der Gestaltung des Plattenkörpers 1. Ein entsprechend vorbereitetes Dekorpapier bzw. eine Folie mit der Dekorschicht 8 lässt sich in variabler Weise auch noch kurz vor dem abschließenden Verarbeitungsschritt, d.h. in der Regel dem Verpressen beispielsweise in einer Kurztaktpresse, dem Schichtaufbau durch Einlegen hinzufügen.

Bei dem in Fig. 2 dargestellten Plattenkörper 1, der sich insbesondere als Bodenbelagselement eignet, sind zwei Gegenzugschichten 9, 10 vorgesehen, nämlich eine erste Gegenzugschicht 9 und eine zweite Gegenzugschicht 10. Die Gegenzugschichten 9, 10 erhöhen die Widerstandsfähigkeit des Plattenkörpers 1 gegen mechanische Verformung.

Die erste Gegenzugschicht 9 und die zweite Gegenzugschicht 10 weisen dabei nicht notwendiger Weise dasselbe Material oder eine gleiche Schichtdicke auf. Es kann beispielsweise vorgesehen sein, dass die erste Gegenzugschicht 9 aus einem vergleichsweise dichten und/oder zähen Material besteht oder dieses aufweist und damit insbesondere einer mechanischen Verformung entgegenwirkt. Die zweite Gegenzugschicht 10 kann dagegen aus einem Material geringerer Dichte bestehen oder dieses aufweisen und insbesondere über schall- und/oder wärmedämmende Eigenschaften verfügen.

Anhand der explosionszeichnungsartigen Darstellung in Fig. 3 lässt sich der Schichtaufbau des Plattenkörpers 1 genauer nachvollziehen. Die Basis des Plattenkörpers 1 wird durch eine Trägerplatte 2, insbesondere aus einem HDF-Material, und eine an der Unterseite der Trägerplatte 2 angeordnete Gegenzugschicht 9 gebildet. Die Gegenzugschicht 9 besteht vorliegend aus Kork, kann jedoch auch aus einer anderem Material bestehen oder ein anderes Material aufweisen. Hierbei kommt insbesondere eine Polymerverbindung oder die Ausbildung der Gegenzugschicht 9 aus einem Pressspanmaterial in Frage.

Oberseitig der Trägerplatte 2 schließt sich unmittelbar die wenigstens eine gedruckte Schaltung aufweisende Funktionsschicht 4 an, welche dem Plattenkörper 1 letztlich seine Funktionalität verleiht. Ergänzend zu dem Aufbau der in den Fig. 1 und 2 gezeigten Plattenkörper 1 ist bei dem in Fig. 3 dargestellten Aufbau oberhalb der Funktionsschicht 4 eine Schutzschicht 11 vorgesehen. Die Schutzschicht 11 weist vorliegend einen isolierenden Schutzlack auf. Dadurch werden Störungen der gedruckten Schaltung der Funktionsschicht 4 beispielsweise durch Kurzschluss von Leiterbahnen 6 aufgrund von eindringender Feuchtigkeit oder eindringendem Schmutz verhindert. Ferner bietet die Schutzschicht 11 einen zusätzlichen Schutz vor mechanischer Beschädigung der Funktionsschicht 4 von der Oberseite her.

Die Schutzschicht 11 kann darüber hinaus die Funktion einer Abstrahlschicht zur Abschirmung von elektromagnetischer und/oder Wärmestrahlung haben. Es versteht sich, dass eine Abstrahlschicht mit der vorgenannten Funktion auch als separate Schicht vorgesehen sein kann.

Oberhalb der Funktionsschicht 4 und der Schutzschicht 11 ist bei der dargestellten Ausführungsform des Plattenkörpers 1 eine Dekorschicht 8 in Form eines Dekorpapiers oder eines Dekorfilms vorgesehen. Alternativ oder zusätzlich kann die Dekorschicht 8 jedoch auch direkt auf eine der anderen Schichten, insbesondere die Funktionsschicht 4, aufgebracht, vorzugsweise gedruckt, sein.

Durch die Dekorschicht 8 erhält der Plattenkörper 1 ein bestimmtes optisches Erscheinungsbild. Die Dekorschicht 8 lässt sich mit nahezu beliebigen Motiven ausstatten, so dass hier ein hohes Maß an Gestaltungsvariabilität vorliegt.

Als oberste Schicht weist der Plattenkörper 1 in der Darstellung gemäß Fig. 3 einen abriebfesten Strukturlack als Deckschicht 3 auf. Die Deckschicht 3 dient zum einen als Schutz vor Verschleiß, beispielsweise durch Abrieb infolge der Benutzung des Plattenkörpers 1. Zum anderen kann das Material der Deckschicht 3 mit einer Oberflächenstrukturierung ausgestattet sein, wodurch der Plattenkörper 1 in seinem optischen und haptischen Erscheinungsbild gestaltet werden kann. Durch die Oberflächenstrukturierung der Deckschicht 3 in Verbindung mit einem entsprechenden Motiv der Dekorschicht 8 lässt sich eine realistische Nachahmung eines natürlichen Werkstoffs erzielen.

Im Hinblick auf die Erkennbarkeit der Dekorschicht 8 ist die Deckschicht 3 vorzugsweise transparent ausgebildet.

Die Funktionsschicht 4 kann, wie erwähnt, einen Aktor 5 in Form einer Leuchtschicht aufweisen. Mittels einer solchen Leuchtschicht kann die Dekorschicht 8 zumindest bereichsweise hinterleuchtet werden. Es versteht sich, dass zu diesem Zweck sowohl die Deckschicht 3 als auch die Schutzschicht 11 vorzugsweise transparent oder zumindest transluzent ausgebildet sind. Die Dekorschicht 8 ist dazu insbesondere auf ein transluzentes Dekorpapier oder eine transluzente und/oder transparente Folie aufgedruckt. Alternativ oder zusätzlich kann die Dekorschicht 8 auch direkt auf die Funktionsschicht 4 mit der Leuchtschicht und/oder die Schutzschicht 11 aufgebracht sein.

Zur Herstellung des Plattenkörpers 1 wird der dargestellte Schichtaufbau, bei dem die einzelnen Schichten übereinander angeordnet sind, durch ein übliches Pressverfahren fest zusammengefügt. Hierbei kommt insbesondere das Verpressen mit einer Kurztaktpresse zum Einsatz, das bei der Herstellung von Plattenkörpern 1 für Boden-, Wand- und/oder Deckenbelägen zu den gängigsten Verfahren zählt. Möglich ist darüber hinaus auch, eine oder mehrere Schichten bei der Herstellung des Plattenkörpers 1 aufzukaschieren. Dies kann insbesondere nach dem Verpressen erfolgen.

Zur Verbindung zweier Plattenkörper 1 weist der dargestellte Plattenkörper 1 bzw. die Trägerplatte 2 an ihren gegenüberliegenden Randseiten korrespondierende Verbindungsgeometrien 12 auf. Die Verbindungsgeometrien 12 sind zur Ausbildung einer Nut-Feder-Verbindung ausgebildet. Der Plattenkörper 1 weist dementsprechend an einer Randseite eine Feder 13 auf. An der gegenüberliegenden Randseite ist dagegen eine korrespondierende Nut 14 zur Aufnahme der Feder 13 eines weiteren Plattenkörpers 1 vorgesehen. Die Verbindungsgeometrien 12 sind vorliegend nach dem weitverbreiteten Prinzip einer Klickverbindung ausgebildet. Hierdurch lässt sich beispielsweise ein Belag aus einer Vielzahl von Plattenkörpern 1 mit geringem Personen-, Zeit- und Materialaufwand verlegen.

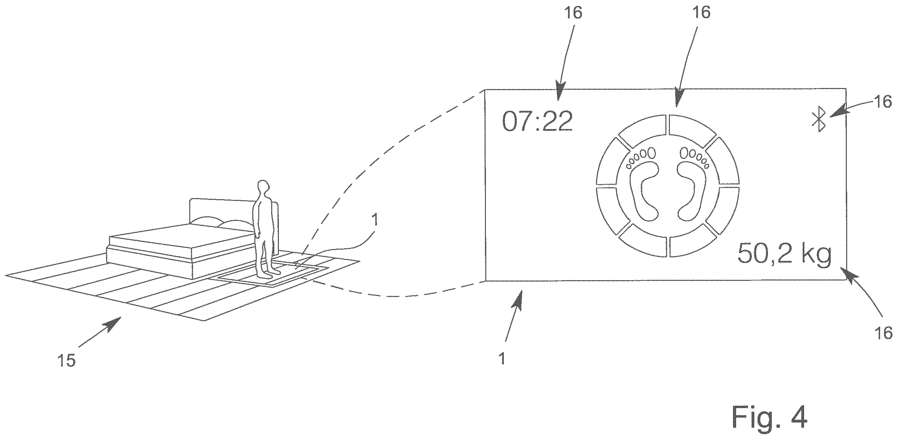

Eine Anwendungssituation für ein System 15 mit einer Mehrzahl von Plattenkörpern 1 ist beispielhaft in Fig. 4 wiedergegeben. Das System 15 ist hier als Bodenbelag ausgebildet und kann in dieser Form im Wohnbereich, beispielsweise in einem Schlafzimmer, eingesetzt werden. Das System 15 weist in einem Bereich wenigstens einen erfindungsgemäßen Plattenkörper 1 mit einer Funktionsschicht 4 auf. Die Funktionsschicht 4 weist ihrerseits eine Reihe von funktionalen Elementen in Form von gedruckten Schaltungen auf. Hierdurch wird die Funktionalität verschiedener, in der Regel jeweils gesondert vorhandener Gegenstände des Haushalts im Sinne einer Smart-Home-Anwendung in dem erfindungsgemäßen Plattenkörper 1 vereinigt.

Beim vorliegenden Beispiel weist der Plattenkörper 1 zunächst die Funktionalität einer Zeitanzeige auf. Hierzu ist eine entsprechende Schaltung mit einem Zeitgeber in der Funktionsschicht 4 vorgesehen. Die Zeitanzeige kann auch als Funkuhr ausgebildet sein und die Funktionsschicht 4 zu diesem Zweck eine Empfangsschaltung für das Signal eines Zeitzeichensenders, wie beispielsweise DCF77, aufweisen.

Zur Visualisierung der Uhrzeit dient ein Anzeigeelement 16. Das Anzeigeelement 16 wird durch einen Aktor 5 in Form einer Leuchtschicht gebildet. Die Leuchtschicht hinter- bzw. durchleuchtet eine vorhandene Dekorschicht 8, so dass das Anzeigeelement 16 nur im aktiven Zustand sichtbar ist. Zur Darstellung verschiedener Zeichen ist die Leuchtschicht des Anzeigeelements 16 bereichsweise aktivierbar. Alternativ kann das Anzeigeelement 16 auch aus einer Vielzahl einzeln aktivierbarer Unterelemente, insbesondere Pixel, bestehen, die durch selektive Aktivierung gemeinsam ein Bild, d.h. ein erkennbares Zeichen, ergeben.

Als Lichtquelle für die Leuchtschicht eignet sich eine Elektrolumineszenz-Folie (EL-Folie). Alternativ oder zusätzlich lässt sich eine Lichtabgabe in der gewünschten Form auch durch Einsatz einer oder mehrerer Leuchtdioden (LEDs), insbesondere organischer Leuchtdioden (OLEDs), bewirken. Ferner kann das Anzeigeelement 16 auch als elektronisches Papier ausgebildet sein, wie es bei gängigen E-Book-Readern zum Einsatz kommt.

Zusätzlich zu der Zeitanzeige kann bei der dargestellten Ausführungsform auch eine Weckfunktion in die Funktionsschicht 4 des Plattenkörpers 1 integriert sein. Hierzu kann die Funktionsschicht 4 einen Aktor 5 in Form eines akustischen Signalgebers aufweisen.

Ferner weist der dargestellte Plattenkörper 1 die Funktionalität einer Körperwaage auf. Die Erfassung des Körpergewichts eines Benutzers, der den Plattenkörper 1 betritt, wird dabei durch einen vorzugsweise als Drucksensor ausgebildeten Sensor 7 in der Funktionsschicht 4 oder einer separaten Sensorschicht realisiert. Die mittels des Sensors 7 gemessenen Gewichtsdaten werden ebenfalls über ein entsprechendes Anzeigeelement 16 visualisiert. Zusätzlich kann eine grafische Darstellung des Verlaufs des gemessen Körpergewichts über einen gewissen Zeitraum dargestellt werden.

Hierzu werden die gemessenen Werte zusammen mit dem Zeitpunkt der Messung in einem Datenspeicher gespeichert und von einer Datenverarbeitungseinrichtung verarbeitet. Der Datenspeicher und/oder die Datenverarbeitungseinrichtung können in der Funktionsschicht 4 in Form einer gedruckten Schaltung vorgesehen sein. Darüber hinaus kann sich der Datenspeicher und/oder die Datenverarbeitungseinrichtung auch außerhalb des Plattenkörpers 1 befinden.

Durch die Datenverarbeitungseinrichtung kann beispielsweise eine Bewertung der gemessenen Daten vorgenommen werden. Dies umfasst insbesondere den Vergleich mit eines gemessenen Werts mit einem Sollwert, wobei eine zu starke Abweichung vom Sollwert beispielsweise durch eine verschiedenfarbige Darstellung durch das Anzeigeelement 16 signalisiert werden kann.

Vorzugsweise weist der Plattenkörper 1 bzw. die Funktionsschicht 4 eine Schaltung mit den Eigenschaften einer Kommunikationseinrichtung auf. Hierdurch lassen sich vorzugsweise gemessene Daten insbesondere per Funk, bevorzugt über eine Bluetooth-Schnittstelle, beispielsweise an eine außerhalb des Plattenkörpers 1 angeordnete Datenverarbeitungseinrichtung übertragen. Möglich ist darüber hinaus auch eine Datenübertragung zu den funktionalen Elementen des Plattenkörpers 1 hin. Dadurch lassen sich insbesondere Konfigurationsdaten übertragen, die etwa zum Einstellen einer Weckzeit und/oder zur Beeinflussung der Darstellung der Anzeigeelemente 16 dienen können.

Die den verschiedenen Funktionalitäten zugeordneten Funktionsgruppen sind in der Funktionsschicht 4 des Plattenkörpers 1 vorliegend nebeneinander, d.h. in verschiedenen Flächenbereichen des Plattenkörpers 1, angeordnet. Sind die Anzeigeelemente 16 derart ausgebildet, dass eine Anzeige durch Hinterleuchtung der Dekorschicht 8 erfolgt, so sind die Anzeigeelemente 16 bei Nichtbenutzung unsichtbar. Der Plattenkörper 1 weist in diesem inaktiven Zustand dementsprechend das optische Erscheinungsbild eines gewöhnlichen Plattenkörpers auf. Die vorgenannte Funktionalität ist damit auf unauffällige Weise in den Bodenbelag des Wohnbereichs integriert.

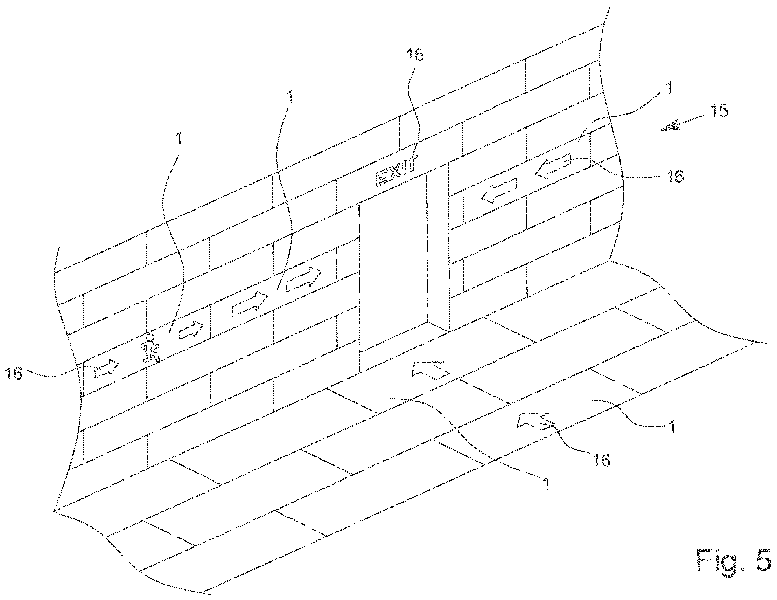

Eine weitere Anwendung eines Systems 15 mit einer Mehrzahl von Plattenkörpern 1, die sich insbesondere für den öffentlichen Bereich eignet, ist in Fig. 5 dargestellt. Hierbei ist eine Vielzahl von Plattenkörpern 1 zu einem Boden- und Wandbelag angeordnet. Das System 15 umfasst eine Mehrzahl erfindungsgemäßer, eine Funktionsschicht 4 aufweisender Plattenkörper 1. Diese Plattenkörper 1 weisen verschiedene Anzeigeelemente 16 auf, die im vorliegenden Anwendungsbeispiel zur Wegkennzeichnung durch eine Pfeildarstellung dienen oder alternativ als Beleuchtungselemente mit einer neutralen Formgebung eingesetzt werden können. Die Kennzeichnungswirkung der Anzeigeelemente 16 kann wie beim vorliegenden Beispiel insbesondere auf einen Notausgang oder einen allgemeinen Fluchtweg gerichtet sein.

Durch eine vorzugsweise ebenfalls in der Funktionsschicht 4 der Plattenkörper 1 vorgesehene Steuereinrichtung lassen sich die Anzeigeelemente 16 bzw. die als Leuchtschicht ausgebildeten Aktoren 5 der Funktionsschicht 4 steuern. Die Steuereinrichtung kann insbesondere mit einem externen Hausalarmsystem gekoppelt sein. Im Alarmfall, d.h. wenn beispielsweise eine Evakuierung des Bereichs erforderlich ist, können so zusätzliche Anzeigeelemente 16 aktiviert werden. Im Fall einer grundsätzlichen Nutzung der Leuchtschicht bzw. der Anzeigeelemente 16 zur allgemeinen Raumgestaltung durch Illumination wird durch die zusätzlichen Anzeigeelemente 16 erst im Alarmfall eine wegkennzeichnende Wirkung erreicht.

Durch eine entsprechende Ansteuerung der Leuchtschicht kann darüber hinaus ein Wechsel der Helligkeit und/oder des Leuchtmodus der Anzeigeelemente 16 bewirkt werden. Hierbei kann beispielsweise von einer statischen Beleuchtung zu einem Blickmodus übergegangen werden, wodurch die Signalwirkung verstärkt wird. Zu diesem Zweck kann zusätzlich eine unterstützende akustische Signalisierung durch einen entsprechenden Aktor 5 in Form eines akustischen Signalgebers vorgesehen sein.

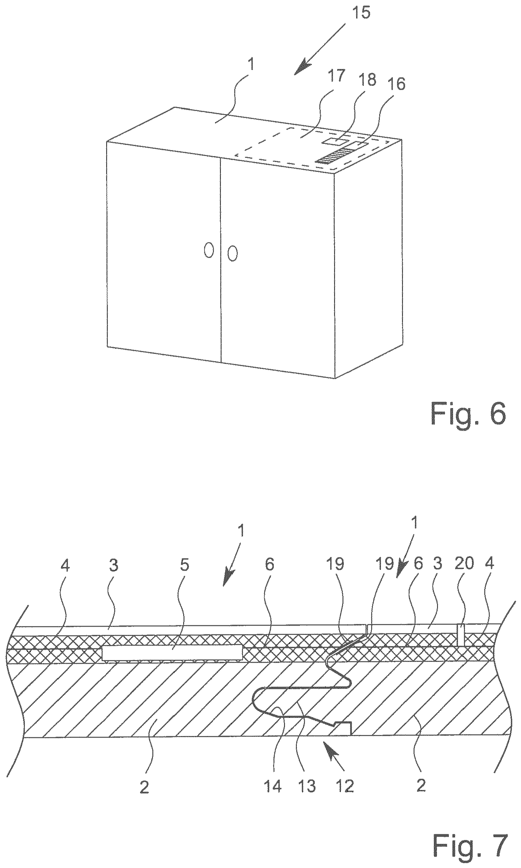

Eine weitere Anwendungsmöglichkeit ergibt sich bei der Herstellung eines Möbelstücks mit funktionalen Elementen. Das in Fig. 6 gezeigte Möbelstück stellt dabei ebenfalls ein erfindungsgemäßes System 15 mit einer Mehrzahl von Plattenkörpern 1 dar. Bei dem gezeigten Möbelstück ist die oberseitige Deckplatte als erfindungsgemäßer Plattenkörper 1 mit einer Funktionsschicht 4 ausgebildet. Der Plattenkörper 1 weist einen Induktionsbereich 17 auf. Der Induktionsbereich 17 kann wie gezeigt nur bereichsweise auf dem Plattenkörper 1 vorgesehen sein, sich jedoch auch vollflächig über den Plattenkörper 1 erstrecken.

Elektronische Geräte, wie beispielsweise Smartphones, lassen sich durch simples Ablegen auf dem Möbelstück im Induktionsbereich 17 aufladen. Die Energieübertragung zum Aufladen erfolgt also kontaktlos durch Funktion des Induktionsbereichs 17 als Ladevorrichtung.

Ferner kann die Ladetätigkeit bzw. der Ladestatus durch ein insbesondere veränderliches Anzeigeelement 16 visualisiert werden.

Eine Bedienungseinrichtung mit einem Bedienelement 18, beispielsweise einem Taster, dient zur Bedienung des funktionalen Elements, d.h. der Ladevorrichtung, durch einen Benutzer. Mittels des Bedienelements 18 kann beispielsweise ein Ladestrom eingestellt oder ein Ladestatus abgefragt werden.

Die Energieversorgung des Plattenkörpers 1 für den Betrieb des Induktionsbereichs 17 kann beispielsweise durch den Anschluss an das elektrische Versorgungsnetz realisiert werden. Dazu dient vorzugsweise ein nicht dargestelltes Anschlusselement zur Kontaktierung der Schaltung bzw. der Leiterbahn 6 in der Funktionsschicht 4 des Plattenkörpers 1.

Die Lademöglichkeit für elektronische Geräte ist im Sinne einer Smart-Home-Anwendung unauffällig in das Möbelstück integriert. Ein spezielles Ladekabel oder eine Dockingstation ist dementsprechend nicht erforderlich. Insbesondere bei Nichtbenutzung der Ladefunktion ist der Induktionsbereich 17 als funktionales Element des Plattenkörpers 1 nicht erkennbar, so dass das Möbelstück ein gewöhnliches Erscheinungsbild besitzt, von dem nicht ohne Weiteres auf die integrierte Funktionalität geschlossen werden kann.

Die in Fig. 7 gezeigte Darstellung des Übergangsbereichs zwischen zwei Plattenkörpern 1 verdeutlicht, wie die randseitigen Verbindungsgeometrien 12 zur Ausbildung einer Verbindung zusammenwirken. Die Feder 13 des einen Plattenkörpers 1 greift dabei in die korrespondierende Nut 14 des anderen Plattenkörpers 1 unter Ausbildung einer reib- und formschlüssigen Verbindung ein.

Die dargestellten, verbundenen Plattenkörper 1 weisen jeweils eine Funktionsschicht 4 auf. In der Funktionsschicht 4 sind funktionale Elemente, wie beispielsweise ein Aktor 5 und eine Leiterbahn 6, vorgesehen. Der Kontakt zwischen der Funktionsschicht 4 des einen Plattenkörpers 1 zu der Funktionsschicht 4 des anderen Plattenkörpers 1 erfolgt über sich berührende Kontaktflächen 19, die jeweils im Bereich der randseitigen Grenzfläche der Funktionsschicht 4 vorgesehen sind.

Die Funktionsschichten 4 sind jeweils derart angefast, dass die einander zugewandten Grenzflächen der Funktionsschichten 4 korrespondierende Formen aufweisen. Die maximale Ausdehnung der Kontaktflächen 19 wird dadurch erheblich vergrößert. Dadurch werden die Übertragungseigenschaften des elektrischen Kontakts zwischen den Funktionsschichten 4 der verbundenen Plattenkörper 1 verbessert, so dass eine störungsfreie oder zumindest störungsarme Energie- und/oder Datenübertragung möglich ist. Zudem ist eine in der vorgenannten Weise ausgebildete Verbindung der Funktionsschichten 4 weniger anfällig für eine Unterbrechung des elektrischen Kontakts infolge einer mechanischen Belastung, insbesondere von der Oberseite des Plattenkörpers 1 her.

Einer der in Fig. 7 gezeigten Plattenkörper 1 weist zudem ein Anschlussmittel 20 zur elektrischen Kontaktierung eines nicht gezeigten elektrischen Verbrauchers auf. Das Anschlussmittel 20 ist im vorliegenden Beispiel als von der Oberseite des Plattenkörpers 1 her zugängliche Buchse ausgebildet. Ein elektrischer Verbraucher kann mittels eines entsprechenden Steckers mit der Leiterbahn 6 verbunden und über diese mit elektrischer Energie versorgt werden.

### Bezugszeichenliste:

- 1: Plattenkörper
- 2: Trägerplatte
- 3: Deckschicht
- 4: Funktionsschicht
- 5: Aktor
- 6: Leiterbahn
- 7: Sensor
- 8: Dekorschicht
- 9: erste Gegenzugschicht
- 10: zweite Gegenzugschicht
- 11: Schutzschicht
- 12: Verbindungsgeometrie
- 13: Feder
- 14: Nut
- 15: System
- 16: Anzeigeelement
- 17: Induktionsbereich
- 18: Bedienelement
- 19: Kontaktfläche
- 20: Anschlussmittel

## Patentansprüche

1. Plattenkörper (1) für einen Boden-, Wand- oder Deckenbelag, für ein Möbel oder eine Fassade, mit einer Trägerplatte (2) und einer oberseitigen Deckschicht (3) oberhalb der Trägerplatte (2),
wobei zwischen der Trägerplatte (2) und der Deckschicht (3) wenigstens eine eine gedruckte Schaltung aufweisende Funktionsschicht (4) mit wenigstens einem Aktor (5) in Form einer Leuchtschicht und/oder mit wenigstens einem mechanischen Aktor (5) und/oder mit wenigstens einer Leiterbahn (6) zur Energieübertragung von elektrischem Strom an einen externen Verbraucher vorgesehen ist und
wobei an gegenüberliegenden Randseiten des Plattenkörpers (1) korrespondierende Nut-Feder-Verbindungsgeometrien (12) vorgesehen sind und
wobei die korrespondierenden Verbindungsgeometrien (12) an den gegenüberliegenden Randseiten derart ausgebildet sind, dass die Funktionsschicht (4) angefast ist, so dass es beim Zusammenfügen zweier benachbarter Plattenkörper (1) zu einer überlappenden Kontaktierung der einander zugewandten Ränder der Funktionsschichten (4) der benachbarten Plattenkörper (1) im Verbindungsbereich kommt, **dadurch gekennzeichnet, dass** der Funktionsschicht (4) wenigstens ein Sensor (7) zur Ermittlung der Temperatur, der Beleuchtungsstärke, von auf den Plattenkörper (1) wirkende Feuchtigkeit und/oder des auf den Plattenkörpers (1) wirkenden Druckes zugeordnet ist.

2. Plattenkörper nach Anspruch 1, **dadurch gekennzeichnet, dass** wenigstens ein vorderseitig und/oder rückseitig und/oder stirnseitig des Plattenkörpers (1) angeordnetes Anschlusselement zur Kontaktierung der Leiterbahn (6) vorgesehen ist.

3. Plattenkörper nach Anspruch 1 oder 2, **dadurch gekennzeichnet, dass** die Funktionsschicht (4) unmittelbar auf die Trägerplatte (2) aufgedruckt ist und/oder dass die gedruckte Schaltung auf einen Schichtträger aufgebracht ist und als separate Schicht zur Verbindung mit der Trägerplatte (2) ausgebildet ist.

4. Plattenkörper nach einem der vorhergehenden Ansprüche, **dadurch gekennzeichnet, dass** die gedruckte Schaltung ein mittels Digitaldruck und/oder Siebdruck und/oder Rollenoffsetdruck aufbringbares, leitfähiges Material, vorzugsweise eine insbesondere Silberpigmente aufweisende Tinte, aufweist.

5. Plattenkörper nach einem der vorhergehenden Ansprüche, **dadurch gekennzeichnet, dass** der Funktionsschicht (4) wenigstens eine Bedienungseinrichtung zur Steuerung der Funktionsschicht (4) zugeordnet ist, wobei die Bedienungseinrichtung vorzugsweise in der Funktionsschicht (4) vorgesehen ist, insbesondere wobei die Bedienungseinrichtung wenigstens einen Druckschalter und/oder ein kapazitives Element aufweist, und/oder dass der Funktionsschicht (4) eine wenigstens ein piezoelektrisches Element aufweisende Schaltung zugeordnet ist.

6. Plattenkörper nach einem der vorhergehenden Ansprüche, **dadurch gekennzeichnet, dass** die Funktionsschicht (4) wenigstens ein photovoltaisches Element aufweist.

7. Plattenkörper nach einem der vorhergehenden Ansprüche, **dadurch gekennzeichnet, dass** die Funktionsschicht (4) wenigstens einen Energiespeicher, vorzugsweise eine insbesondere gedruckte Dünnschichtbatterie, aufweist.

8. Plattenkörper nach einem der vorhergehenden Ansprüche, **dadurch gekennzeichnet, dass** eine Negativmaskenschicht zum Ausgleich von überstehenden Konturen der Funktionsschicht (4) vorgesehen ist, insbesondere wobei die Negativmaskenschicht im Bereich der Funktionsschicht (4) eine geringere Schichtdicke aufweist als in Bereichen, in denen keine Funktionsschicht (4) vorgesehen ist, und/oder wobei die Negativmaskenschicht als Lackschicht ausgebildet ist.

9. Plattenkörper nach einem der vorhergehenden Ansprüche, **dadurch gekennzeichnet, dass** die Negativmaskenschicht wenigstens einen Ausschnitt zur Anordnung von überstehenden Konturen der Funktionsschicht (4) aufweist.

10. Plattenkörper nach einem der vorhergehenden Ansprüche, **dadurch gekennzeichnet, dass** zwischen der Funktionsschicht (4) und der Trägerplatte (2) wenigstens eine Stabilisierungsschicht, insbesondere eine Glasfaser- und/oder Polyesterschicht, vorgesehen ist.

11. Plattenkörper nach einem der vorhergehenden Ansprüche, **dadurch gekennzeichnet, dass** unterhalb der Deckschicht (3) eine Dekorschicht (8) vorgesehen ist, wobei die Funktionsschicht (4) vorzugsweise zwischen der Dekorschicht (8) und der Trägerplatte (2) angeordnet ist, insbesondere wobei die Dekorschicht als Negativmaskenschicht ausgebildet ist und/oder wobei die Dekorschicht (8) auf ein vorzugsweise transluzentes Dekorpapier, auf eine vorzugsweise transparente Folie und/oder unmittelbar auf die Funktionsschicht (4) aufgedruckt ist.

12. Plattenkörper (1) nach einem der vorhergehenden Ansprüche, **dadurch gekennzeichnet, dass** zwischen der Trägerplatte (2) und der Deckschicht (3) die wenigstens eine Funktionsschicht (4) mit wenigstens einem Anzeigemittel vorgesehen ist.

13. Plattenkörper nach Anspruch 12, **dadurch gekennzeichnet, dass** das Anzeigemittel als elektronisches Papier ausgebildet ist oder ein solches aufweist.

14. System (15) mit einer Mehrzahl von Plattenkörpern (1), aufweisend wenigstens einen eine Funktionsschicht (4) aufweisenden Plattenkörper (1) nach einem der vorhergehenden Ansprüche.

## Claims

1. Panel element (1) for a floor, wall or ceiling covering, for an item of furniture or a facade, comprising a carrier panel (2) and a top-side cover layer (3) on top of the carrier panel (2),
wherein at least one functional layer (4) comprising a printed circuit with at least one actuator (5) in the form of a luminous layer and/or with at least one mechanical actuator (5) and/or with at least one conductive track (6) is provided between the carrier panel (2) and the cover layer (3) for transmitting energy from electric current to an external consumer and
wherein corresponding tongue-and-groove connection geometries (12) are provided on opposite edge sides of the panel element (1) and
wherein the corresponding connection geometries (12) are formed on the opposite edge sides in such a way that the functional layer (4) is chamfered, so that when two adjacent panel elements (1) are joined together, overlapping contact is made between the facing edges of the functional layers (4) of the adjacent panel elements (1) in the connection region,
**characterized in that**
at least one sensor (7) is associated with the functional layer (4) for determining the temperature, the illumination intensity, the moisture acting on the panel element (1) and/or the pressure acting on the panel element (1).

2. Panel element according to claim 1, **characterized in that** at least one connecting element arranged at the front and/or rear and/or end of the panel element (1) is provided for contacting the conductive track (6).

3. Panel element according to claim 1 or 2, **characterized in that** the functional layer (4) is printed directly onto the carrier panel (2) and/or that the printed circuit is applied to a layer carrier and is formed as a separate layer for connection to the carrier panel (2).

4. Panel element according to one of the preceding claims, **characterized in that** the printed circuit comprises a conductive material which can be applied by means of digital printing and/or screen printing and/or web offset printing, preferably an ink comprising in particular silver pigments.

5. Panel element according to one of the preceding claims, **characterized in that** at least one operating device for controlling the functional layer (4) is assigned to the functional layer (4), the operating device preferably being provided in the functional layer (4), in particular the operating device having at least one pressure switch and/or a capacitive element, and/or **in that** a circuit having at least one piezoelectric element is assigned to the functional layer (4).

6. Panel element according to any of the preceding claims, **characterized in that** the functional layer (4) comprises at least one photovoltaic element.

7. Panel element according to one of the preceding claims, **characterized in that** the functional layer (4) comprises at least one energy storage device, preferably a thin-film battery, in particular a printed thin-film battery.

8. Panel element according to one of the preceding claims, **characterized in that** a negative mask layer is provided for compensating protruding contours of the functional layer (4), in particular wherein the region of the functional layer (4) the negative mask layer has a smaller layer thickness than in regions in which no functional layer (4) is provided, and/or wherein the negative mask layer is formed as a lacquer layer.

9. Panel element according to one of the preceding claims, **characterized in that** the negative mask layer has at least one cut-out for the arrangement of protruding contours of the functional layer (4).

10. Panel element according to one of the preceding claims, **characterized in that** at least one stabilizing layer, in particular a glass fiber and/or polyester layer, is provided between the functional layer (4) and the carrier panel (2).

11. Panel element according to one of the preceding claims, **characterized in that** a decorative layer (8) is provided below the cover layer (3), the functional layer (4) preferably being arranged between the decorative layer (8) and the carrier panel (2), in particular the decorative layer being designed as a negative mask layer and/or the decorative layer (8) being printed on a preferably translucent decorative paper, on a preferably transparent film and/or directly on the functional layer (4).

12. Panel element (1) according to one of the preceding claims, **characterized in that** between the carrier panel (2) and the cover layer (3) the at least one functional layer (4) with at least one display means is provided.

13. Panel element according to claim 12, **characterized in that** the display means is formed as or comprises an electronic paper.

14. System (15) with a plurality of panel elements (1), comprising at least one panel element (1) having a functional layer (4) according to one of the preceding claims.

## Revendications

1. Corps de panneau (1) pour un revêtement de sol, de mur ou de plafond, pour un meuble ou une façade, avec une plaque de support (2) et une couche de surface (3) au-dessus de la plaque de support (2),
dans lequel, entre la plaque de support (2) et la couche de surface (3), il est prévu au moins une couche fonctionnelle (4) comprenant un circuit imprimé avec au moins un actionneur (5) sous la forme d'une couche luminescente et/ou avec au moins un actionneur mécanique (5) et/ou avec au moins une piste conductrice (6) pour transmettre l'énergie du courant électrique à un consommateur externe et
dans lequel des géométries de raccordement à rainure et languette (12) correspondantes sont prévues sur les côtés de bord opposés du corps du panneau (1) et
les géométries de raccordement (12) correspondantes étant formées sur les côtés de bord opposés de telle sorte que la couche fonctionnelle (4) soit chanfreinée, de sorte que, lors de l'assemblage de deux corps de panneau (1) voisins, un contact par chevauchement des bords opposés des couches fonctionnelles (4) des corps de panneau (1) voisins se produise dans la zone de raccordement,
**caractérisé en ce que**
au moins un capteur (7) est associé à la couche fonctionnelle (4) pour déterminer la température, l'intensité d'éclairage, l'humidité agissant sur le corps de panneau (1) et/ou la pression agissant sur le corps de panneau (1).

2. Corps de panneau selon la revendication 1, **caractérisé en ce qu'**au moins un élément de connexion disposé à l'avant et/ou à l'arrière et/ou à l'extrémité du corps de panneau (1) est prévu pour la mise en contact avec la piste conductrice (6).

3. Corps de panneau selon la revendication 1 ou 2, **caractérisé en ce que** la couche fonctionnelle (4) est imprimée directement sur la plaque de support (2) et/ou que le circuit imprimé est appliqué sur un support de couche et est formé comme une couche séparée pour la connexion à la plaque de support (2).

4. Corps de panneau selon l'une quelconque des revendications précédentes, **caractérisé en ce que** le circuit imprimé comprend un matériau conducteur, de préférence une encre contenant en particulier des pigments d'argent, qui peut être appliqué au moyen d'une impression numérique et/ou d'une sérigraphie et/ou d'une impression offset sur bande.

5. Corps de panneau selon l'une quelconque des revendications précédentes, **caractérisé en ce qu'**au moins un dispositif de commande pour la commande de la couche fonctionnelle (4) est associé à la couche fonctionnelle (4), le dispositif de commande étant prévu de préférence dans la couche fonctionnelle (4), en particulier le dispositif de commande présentant au moins un interrupteur à pression et/ou un élément capacitif, et/ou **en ce qu'**un circuit présentant au moins un élément piézoélectrique est associé à la couche fonctionnelle (4).

6. Corps de panneau selon l'une quelconque des revendications précédentes, **caractérisé en ce que** la couche fonctionnelle (4) comprend au moins un élément photovoltaïque.

7. Corps de panneau selon l'une quelconque des revendications précédentes, **caractérisé en ce que** la couche fonctionnelle (4) comprend au moins un stockage d'énergie, de préférence une batterie à couche mince imprimée.

8. Corps de panneau selon l'une quelconque des revendications précédentes, **caractérisé en ce qu'**une couche de masque négative est prévue pour compenser les contours saillants de la couche fonctionnelle (4), en particulier la couche de masque négative présentant une épaisseur de couche plus faible dans la zone de la couche fonctionnelle (4) que dans les zones dans lesquelles aucune couche fonctionnelle (4) n'est prévue, et/ou la couche de masque négative étant formée comme une couche de vernis.

9. Corps de panneau selon l'une quelconque des revendications précédentes, **caractérisé en ce que** la couche de masque négative présente au moins une découpe pour l'agencement des contours saillants de la couche fonctionnelle (4).

10. Corps de panneau selon l'une quelconque des revendications précédentes, **caractérisé en ce qu'**au moins une couche de stabilisation, en particulier une couche de fibre de verre et/ou de polyester, est prévue entre la couche fonctionnelle (4) et la plaque de support (2).

11. Corps de panneau selon l'une quelconque des revendications précédentes, **caractérisé en ce qu'**une couche décorative (8) est prévue sous la couche de surface (3), la couche fonctionnelle (4) étant de préférence disposée entre la couche décorative (8) et la plaque de support (2), en particulier dans lequel la couche décorative est conçue comme une couche de masque négative et/ou dans lequel la couche décorative (8) est imprimée sur un papier décoratif de préférence translucide, sur un film de préférence transparent et/ou directement sur la couche fonctionnelle (4).

12. Corps de panneau (1) selon l'une quelconque des revendications précédentes, **caractérisé en ce qu'**entre la plaque de support (2) et la couche de surface (3) est prévue au moins une couche fonctionnelle (4) avec au moins un moyen d'indication.

13. Corps de panneau selon la revendication 12, **caractérisé en ce que** le moyen d'indication est formé comme ou comprend du papier électronique.

14. Système (15) avec une pluralité de corps de panneau (1), comprenant au moins un corps de panneau (1) comportant une couche fonctionnelle (4) selon l'une quelconque des revendications précédentes.
